Europäisches Patentamt

(19) European Patent Office

Office européen des brevets

(11) Veröffentlichungsnummer : **0 284 112 B1**

(12) # EUROPÄISCHE PATENTSCHRIFT

(45) Veröffentlichungstag der Patentschrift :
22.05.91 Patentblatt 91/21

(51) Int. Cl.⁵ : **G11B 13/04**

(21) Anmeldenummer : **88200093.8**

(22) Anmeldetag : **20.01.88**

(54) **Magneto-optischer Speicher und Verfahren zu seiner Herstellung.**

(30) Priorität : **28.01.87 DE 3702480**

(43) Veröffentlichungstag der Anmeldung :
**28.09.88 Patentblatt 88/39**

(45) Bekanntmachung des Hinweises auf die
Patenterteilung :
**22.05.91 Patentblatt 91/21**

(84) Benannte Vertragsstaaten :
**DE FR GB IT NL**

(56) Entgegenhaltungen :
EP-A- 0 161 807
PATENT ABSTRACTS OF JAPAN, Band 9, Nr.
64 (P-343)(1787) 23. März 1985; & JP - A - 59 198
544
PATENT ABSTRACTS OF JAPAN, Band 10, Nr.
132, (P-456)(2189), 16. Mai 1986; & JP - A - 60
254 434
CHEMICAL ABSTRACTS, Band 105, 1986,
Seite 23, Zusammenfassungs-Nr. 209695m,
Columbus, Ohio, US; Z. NOVOTNY: "Plasma
deposition of silicon-containing polymer and
some of its physical properties", & CZECH.J.-
PHYS. 1986, B36 (7)806-813

(73) Patentinhaber : **Philips Patentverwaltung GmbH**
**Wendenstrasse 35 Postfach 10 51 49**
**W-2000 Hamburg 1 (DE)**
**DE**
Patentinhaber : **N.V. Philips'**
**Gloeilampenfabrieken**
**Groenewoudseweg 1**
**NL-5621 BA Eindhoven (NL)**
**FR GB IT NL**

(72) Erfinder : **Gerstenberg, Klaus, Dr.**
**Papenmoorweg 2**
**W-2083 Halstenbek (DE)**
Erfinder : **Heitmann, Heinrich, Dr.**
**Rehrhöfe 8**
**W-2090 Winsen/Luhe (DE)**

(74) Vertreter : **Nehmzow-David, Fritzi-Maria et al**
**Philips Patentverwaltung GmbH**
**Wendenstrasse 35 Postfach 10 51 49**
**W-2000 Hamburg 1 (DE)**

**Beschreibung**

Die Erfindung betrifft einen magneto-optischen Speicher mit einem Substrat aus einem für den sichtbaren bis infraroten Spektralbereich transparenten Material, auf dem nacheinander eine dielektrische, für den sichtbaren bis infraroten Spektralbereich transparente Schicht mit einem Brechungsindex, der größer als der Brechungsindex des Substrates ist und die eine Diffusionsbarriere für Sauerstoff und/oder Wasser darstellt, eine im wesentlichen amorphe und/oder im wesentlichen mikrokristalline magneto-optische Schicht mit uniaxialer Anisotropie und einer magnetischen Ordnungstemperatur > Raumtemperatur und eine Deckschicht, die als Reflexions- oder Interferenzschicht und als Diffusionsbarriere für Sauerstoff und/oder Wasser wirksam ist, angebracht sind sowie ein Verfahren zu seiner Herstellung.

Bei löschbaren magneto-optischen Speichern kann das Einschreiben, Auslesen und Löschen von Information durch Anwendung einer lokalisierten elektromagnetischen Strahlung bewirkt werden.

Das Auslesen von Information erfolgt unter Ausnutzung entweder des magneto-optischen Kerr-Effektes in Reflexion oder des Faraday-Effektes in Transmission.

Ein löschbarer magneto-optischer Speicher mit einem im wesentlichen amorphen und/oder im wesentlichen mikrokristallinen magneto-optischen Speichermaterial ist z.B. aus DE-PS 23 40 475 bekannt.

Die dielektrische Schicht hat die Aufgabe, den Kerr-Effekt des magneto-optischen Speichers zu erhöhen und das Einschreib-, Auslese- und Löschverhalten des magneto-optischen Speichers zu optimieren.

Zur Optimierung des Auslesewirkungsgrades ist es zweckmäßig, daß oberhalb der magneto-optischen Schicht eine Schicht vorhanden ist, die entweder als Reflexions- oder als Interferenzschicht wirksam ist (Deckschicht).

Alle an die magneto-optische Schicht angrenzenden Schichten haben außerdem die weitere Funktion, die magneto-optische Schicht vor die Langzeitlebensdauer eines Speichers beeinträchtigenden Umwelteinflüssen, z.B. Oxidation oder Korrosion, zu schützen.

Wird ein Substrat aus einem Kunststoff, wie z.B. Polycarbonat, verwendet, sind an die Eigenschaften der dielektrischen Schicht besondere Anforderungen zu stellen. Das Aufbringen der dielektrischen Schicht darf nur bei relativ niedrigen Temperaturen (< 80°C) erfolgen, da sonst das Substrat in Mitleidenschaft gezogen wird. Hiermit ist jedoch das Problem verbunden, daß auf dem Kunststoffsubstrat angebrachte Schichten schlecht haften. Die dielektrische Schicht muß mechanisch belastbar sein, d.h. sie muß elastisch sein, so daß sie Eigenspannungen der auf ihr angebrachten magneto-optischen Schicht kompensieren kann und auch bei Verformungen des elastischen Substrates nicht reißt oder abplatzt. Die dielektrische Schicht, die eine Passivierungsschicht für die magneto-optische Schicht darstellt, muß chemisch stabil sein und darf keine Reaktionen mit dem Material der magneto-optischen Schicht zeigen. Die optischen Eigenschaften der dielektrischen Schicht müssen derart sein, daß sie bei einer Wellenlänge von 800 nm, dem Arbeitsbereich eines mit den magneto-optischen Speicher zusammenwirkenden Lasers, einen Brechungsindex im Bereich von 1,9 bis 2,5 hat, wobei die Absorption bei dieser Wellenlänge gering sein muß (Absorptionskoeffizient $k < 0,05$).

Die Kombination aller erforderlicher Eigenschaften ist bei den für die genannten dielektrischen Schichten verwendeten bekannten Materialien wie, z.B. AlN, $SiO_2$, $CeO_2$, $Al_2O_3$, nicht gegeben (vgl. EP-A 161 807). Bei sauerstoffhaltigen Materialien für die dielektrische Schicht besteht die Gefahr, daß die mit ihr in Kontakt stehende magneto-optische Schicht in ihren Eigenschaften z.B. durch Diffusionsprozesse verändert und beeinträchtigt wird. $SiO_2$ hat darüberhinaus für den genannten Anwendungszweck einen zu geringen Brechungsindex. Dielektrische Schichten aus allen oben genannten Materialien haben außerdem eine zu geringe Bruchdehnung, so daß sie bei mechanischer Belastung eines relativ elastischen Substrates Risse bekommen oder abplatzen und damit als Passivierungsschichten nicht mehr ihre Funktion erfüllen.

Der Erfindung liegt die Aufgabe zugrunde, einen magneto-optischen Speicher mit insbesondere einem elastischen Substrat und mit einer dielektrischen Schicht als optischer Anpassungsschicht zu schaffen, die die erforderlichen optischen und verbesserte mechanische Eigenschaften aufweist und keine Wechselwirkungen mit der mit ihr in Kontakt stehenden magneto-optischen Schicht zeigt.

Diese Aufgabe wird erfindungsgemäß dadurch gelöst, daß die dielektrische Schicht in unmittelbarem Kontakt mit dem Substrat ist und aus Hexamethyldisilazan $C_6H_{19}NSi_2$ mittels eines PCVD (plasma activated chemical vapour deposition)-Prozesses erhältlich ist.

Nach einer vorteilhaften Weiterbildung der Erfindung ist die dielektrische Schicht eine aus Hexamethyldisilazan $C_6H_{19}NSi_2$ abgeschiedene Schicht. Bei Versuchen, die zur vorliegenden Erfindung geführt haben, hat sich gezeigt, daß Schichten, die aus Hexamethyldisilazan abgeschieden wurden, nicht nur eine ausgezeichnete Diffusionsbarriere für Sauerstoff und/oder Wasser, die die Eigenschaften der magneto-optischen Schicht beeinträchtigen, darstellen, sondern daß auch ihr Bruchdehnungsverhalten so gut ist, daß Eigenspannungen der magneto-optischen Schicht kompensiert werden können.

Darüberhinaus liegt der Brechungsindex der erfindungsgemäßen dielektrischen Schichten im für die Anwendung von magneto-optischen Speichern interessierenden Wellenlängenbereich von 800 nm im Bereich von 1,9 bis 2,5 mit einem Absorptionskoeffizienten k < 0,05, so daß diese Schichten ihre Funktion als optische Anpassungsschicht gut erfüllen.

Nach einer weiteren vorteilhaften Ausgestaltung der Erfindung ist zwischen der magneto-optischen Schicht und der Deckschicht eine weitere dielektrische, für den sichtbaren bis infraroten Spektralbereich transparente Schicht, vorzugsweise eine aus Hexamethyldisilazan abgeschiedene Schicht, angebracht.

Es ist also möglich, magneto-optische Speicher gemäß der Erfindung auch in sogenannter Quadrilayer-Anordnung zu schaffen.

Ein besonderer Vorteil des für die Bildung der dielektrischen Schicht(en) eingesetzten Hexamethyldisilazans ist, daß für den Aufbau magneto-optischer Speicher magneto-optische Schichten unterschiedlichster Zusammensetzungen einsetzbar sind. Für die an die dielektrische(n) Schicht(en) angrenzende magneto-optische Schicht kann als Material ein ternäres oder quaternäres System aus mindestens einem Seltenerdmetall und mindestens einem Übergangsmetall und gegebenenfalls mindestens einer weiteren metallischen Komponente gewählt werden, wie z.B. ein ternäres oder quaternäres System von Gadolinium und/oder Terbium und Eisen und/oder Kobalt. Vorzugsweise wird für die magneto-optische Schicht Gadolinium/Terbium/Eisen oder Terbium/Eisen/Kobalt gewählt.

Ein Verfahren zur Herstellung eines magneto-optischen Speichers mit einem Substrat aus einem für den sichtbaren bis infraroten Spektralbereich transparenten Material, auf das nacheinander eine dielektrische, für den sichtbaren bis infraroten Spektralbereich transparente Schicht mit einem Brechungsindex, der größer als der Brechungsindex des Substrats ist und die eine Diffusionsbarriere für Sauerstoff und/oder Wasser darstellt, eine im wesentlichen amorphe und/oder im wesentlichen mikrokristalline magnetooptische Schicht mit uniaxialer Anisotropie und einer magnetischen Ordnungstemperatur größer Raumtemperatur und eine Deckschicht, die als Reflexions- oder Interferenzschicht und als Diffusionsbarriere für Sauerstoff und/oder Wasser wirksam ist, aufgebracht sind, ist dadurch gekennzeichnet, daß die dielektrische Schicht aus Hexamethyldisilazan $C_6H_{19}NSi_2$ in einem PCVD (plasma activated chemical vapour deposition)-Prozeß auf dem Substrat abgeschieden wird.

Nach einer vorteilhaften Weiterbildung des Verfahrens nach der Erfindung wird vor Einleiten des Prozeßgases Hexamethyldisilazan zunächst Stickstoff bis zu einem Druck im Bereich von 0,5 bis 150 Pa in den Rezipienten eingeleitet und das Plasma wird bei einem Gleichspannungspotential an der HF-Elektrode im Bereich von 100 bis 1000 V gezündet, wonach nach einer Dauer von 20 bis 300 s Hexamethyldisilazan als Prozeßgas kontinuierlich zugeführt wird bis zu einem Druck im Bereich von 0,5 bis 150 Pa, wobei der Beschichtungsprozeß bis zum Erreichen der gewünschten Schichtdicke fortgeführt wird. Hierdurch wird infolge von backsputter-Effekten am zu beschichtenden Substrat nicht nur zunächst eine Reinigung des Substrates sondern auch eine Aktivierung der zu beschichtenden Substratoberfläche bewirkt, was zu einer optimierten Haftung der aus Hexamethyldisilazan abgeschiedenen Schicht am Substrat führt.

Nach einer weiteren vorteilhaften Ausgestaltung des Verfahrens gemäß der Erfindung wird der Beschichtungsprozeß mit einem Gasgemisch aus Hexamethyldisilazan mit einem Stickstoff-Anteil von 0 bis 50 Vol.% durchgeführt. Wenn ein gewisser Anteil von Stickstoff im Prozeßgas enthalten ist, ergibt sich der Vorteil einer besonders guten Plasmastabilität.

Die mit der Erfindung erzielbaren Vorteile bestehen insbesondere darin, daß die Langzeitstabilität magneto-optischer Speicher, die durch untere und obere Grenzen der magnetischen Eigenschaften des magneto-optischen Materials, wie z.B. die Anisotropie $K_u$, die Koerzitivfeldstärke $H_c$ oder die Kompensationstemperatur $T_{comp}$, gegeben ist und die durch insbesondere Diffusionsprozesse von Sauerstoff und/oder Wasser in den Grenzbereichen der magneto-optischen Schicht beeinträchtigt wird, durch aus organischen Siliconen abgeschiedene Schichten an den Grenzen der magneto-optischen Schicht verbessert wird, weil derartige dielektrische Schichten keine Wechselwirkungen mit dem Material der magneto-optischen Schicht zeigen und eine ausreichend hohe Bruchdehnung haben, so daß sie auch auf Kunststoffsubstraten, die relativ elastisch sind, eingesetzt werden können. Hiermit ist der für die praktische Anwendung löschbarer magneto-optischer Speicher sehr wichtige Vorteil verbunden, daß diese auch über lange Benutzungszeiträume reproduzierbar genau arbeiten.

Im folgenden wird ein Ausführungsbeispiel der Erfindung zur Herstellung von dielektrischen Schichten unter Verwendung von Hexamethyldisilazan beschrieben.

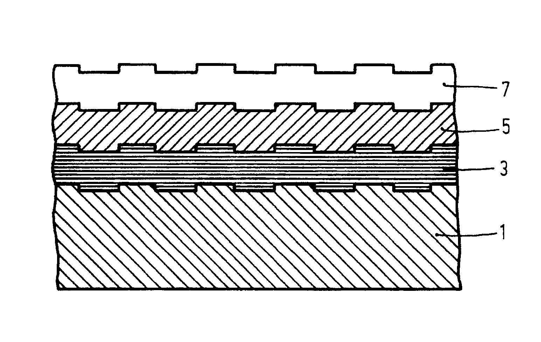

In Figur 1 ist eine für den Aufbau eines magneto-optischen Speichers geeignete Schichtenfolge dargestellt.

Nacheinander sind auf ein durch Führungsrillen strukturiertes Polycarbonat-Substrat 1 einer Dicke von z.B. 1 mm eine dielektrische aus Hexamethyldisilazan abgeschiedene Schicht 3 einer Dicke von 80 nm, eine magneto-optische Schicht 5 z.B. aus weitgehend amorphem GdTbFe einer Dicke von 45 nm und eine als Reflexionsschicht wirksame Deckschicht 7, z.B. aus Al, einer Dicke von 30 nm angebracht.

Die Abscheidung der Schichten erfolgt mit folgenden Parametern :

Auf dem Substrat 1 wird zunächst die dielektrische Schicht 3 aus Hexamethyldisilazan $C_6H_{19}NSi_2$ mit einer Dicke von 80 nm abgeschieden. Hierzu wird eine Einelektroden-PCVD-Anlage bis auf einen Restgasdruck von einigen $10^{-2}$ Pa, vorzugsweise $2 \times 10^{-2}$ Pa, evakuiert. Das zu beschichtende Substrat 1 befindet sich auf der Elektrode und erreicht im Laufe des Prozesses keine Temperatur > 80°C. Zum Erreichen einer guten Haftung der dielektrischen Schicht 3 am Substrat 1 wird in den Rezipienten Stickstoff in einer Menge von 6 sccm/min bis zu einem Druck von p $\approx$ 1 Pa eingeleitet. Anschließend wird das Plasma unter Verwendung eines 13,56 MHz-Generators gezündet. Das sich an der HFElektrode einstellende Gleichspannungspotential beträgt 200 V. Nach einer Dauer von $\approx$ 200 s wird das Prozeßgas Hexamethyldisilazan in einer Menge von 10 sccm/min eingeleitet bis zu einem Druck von p = 2 Pa im Rezipienten und der Zustrom von Stickstoff wird gedrosselt ; der Beschichtungsprozeß des Substrates schließt sich also kontinuierlich an den Prozeß der Vorbereitung der Substratoberfläche mittels Stickstoff an. Für die Beschichtung des Substrates wird das Gleichspannungspotential an der HF-Elektrode auf 500 V eingestellt. Nach einer Dauer von $\approx$ 110 s ist aus Hexamethyldisilazan eine Schicht einer Schichtdicke von 80 nm auf dem Substrat 1 abgeschieden.

Mit dem vorliegenden Verfahren wurden dielektrische Schichten mit folgenden Eigenschaften hergestellt :

Brechungsindex bei 800 nm : 1,99
Absorptionskoeffizient k bei 800 nm : 0,03
Bruchdehnung : > 1%
Innere Spannung (Druck) : 500 MPa
Dichte : 1,7 $g/cm^3$.

Das beschichtete Substrat 1 mit der dielektrischen Schicht 3 wird der Anlage nach Abschalten der HF-Versorgung, Abschalten der Gaszufuhr und Belüften des Rezipienten entnommen und anschließend mit der magneto-optischen Schicht 5 versehen. Hierzu wird z.B. auf bekannte Weise so vorgegangen, daß durch Magnetron-Kathodenzerstäubung eine 45 nm dicke GdTbFe-Schicht mittels eines der gewünschten Schichtzusammensetzung entsprechenden Targets abgeschieden wird. Dazu wird im Rezipienten ein Argondruck von p = 1 Pa eingestellt und die Schicht wird bei einer Anodenspannung von 250 V unter einem Magnetfeld von $32.10^3$ A/m bei einer Leistungsdichte von 1,6 $J/s/cm^2$ abgeschieden. Anschließend wird auf der magneto-optischen Schicht 5 eine als Reflexionsschicht wirksame Deckschicht 7 aus Al einer Dicke von 30 nm mittels eines hochreinen Aluminium-Targets abgeschieden. Hierzu wird im Rezipienten ein Argondruck von p = 0,7 Pa eingestellt. Die Schicht wird bei einer Anodenspannung von 390 V unter einem Magnetfeld von $50.10^3$ A/m und bei einer Leistungsdichte von 1,5 $J/s/cm^2$ abgeschieden.

Eine für die Herstellung eines solchen Schichtaufbaus einzusetzende Magnetron-Kathodenzerstäubungsanlage sollte zweckmäßigerweise mehrere mit entsprechenden Targets ausgestattete Sputterkathoden aufweisen, damit das zu beschichtende Substrat samt dielektrischer Schicht in einem einzigen kontinuierlichen Prozeß mit weiteren Schichten unterschiedlicher chemischer Zusammensetzung versehen werden kann, ohne daß die Vorrichtung geöffnet werden muß, damit die Anlagerung z.B. von Sauerstoff minimiert wird.

## Ansprüche

1. Magneto-optischer Speicher mit einem Substrat (1) aus einem für den sichtbaren bis infraroten Spektralbereich transparenten Material, auf dem nacheinander eine dielektritransparente Schicht (3) mit einem Brechungsindex, der größer als der Brechungsindex des Substrates ist und die eine Diffusionsbarriere für Sauerstoff und/oder Wasser darstellt, eine im wesentlichen amorphe und/oder im,wesentlichen mikrokristalline magneto-optische Schicht (5) mit uniaxialer Anisotropie und einer magnetischen Ordnungstemperatur > Raumtemperatur und eine Deckschicht (7), die als Reflexions- oder Interferenzschicht und als Diffusions-barriere für Sauerstoff und/oder Wasser wirksam ist, angebracht sind, dadurch gekennzeichnet, daß die dielektrische Schicht in unmittelbarem Kontakt mit dem Substrat ist und aus Hexamethyldisilazan $C_6H_{19}NSi_2$ mittels eines PCVD (plasma activated chemical vapour deposition)-Prozesses erhältlich ist.

2. Magneto-optischer Speicher nach Anspruch 1, dadurch gekennzeichnet, daß zwischen er magneto-optischen Schicht (5) und der Deckschicht (3) eine weitere dielektrische, für den sichtbaren bis infraroten Spektralbereich transparente Schicht, vorzugsweise eine aus Hexamethyldisilazan abgeschiedene Schicht, angebracht ist.

3. Magneto-optischer Speicher nach den Ansprüchen 1 und 2, dadurch gekennzeichnet, Naß das Substrat (1) aus Kunststoff, insbesondere aus einem Polycarbonat, besteht.

4. Magneto-optischer Speicher nach den Ansprüchen 1 und 2, dadurch gekennzeichnet, daß das Substrat (1) aus Glas besteht.

5. Magneto-optischer Speicher nach einem der vorhergehenden Ansprüche 1 bis 4, dadurch gekennzeichnet, daß die magneto-optische Schicht (5) aus einem Material aus einem ternären oder quaternären System aus mindestens einem Seltenerdmetall und mindestens einem Übergangsmetall und gegebenenfalls mindestens einer weiteren metallischen Komponente besteht.

6. Magneto-optischer Speicher nach Anspruch 5, dadurch gekennzeichnet, daß die magneto-optische Schicht (5) aus einem Material aus einem ternären oder quaternären System von Gadolinium und/oder Terbium und Eisen und/oder Kobalt besteht.

7. Magneto-optischer Speicher nach Anspruch 6, dadurch gekennzeichnet, daß die magneto-optische Schicht (5) aus Gadolinium/Terbium/ Eisen oder Terbium/Eisen/Kobalt besteht.

8. Magneto-optischer Speicher nach einem der vorhergehenden Ansprüche 1 bis 7, dadurch gekennzeichnet, daß die Deckschicht (7) aus Metall oder aus einem Oxid, Nitrid oder Oxinitrid eines Metalls oder eines Halbleiters besteht.

9. Verfahren zur Herstellung eines magneto-optischen Speichers nach den Ansprüchen 1 bis 8 mit einem Substrat (1) aus einem für den sichtbaren bis infraroten Spektralbereich transparenten Material, auf das nacheinander eine dielektrische, für den sichtbaren bis infraroten Spektralbereich transparente Schicht (5) mit einem Brechungsindex, der größer als der Brechungsindex des Substrates ist und die eine Diffusionsbarriere für Sauerstoff und/oder Wasser darstellt, eine im wesentlichen amorphe und/oder im wesentlichen mikrokristalline magneto-optische Schicht (5) mit uniaxialer Anisotropie und einer magnetischen Ordnungstemperatur > Raumtemperatur und eine Deckschicht (7), die als Reflexions- oder Interferenzschicht und als Diffusions-barriere für Sauerstoff und/oder Wasser wirksam ist, aufgebracht sind, dadurch gekennzeichnet, daß die dielektrische Schicht aus Hexamethyldisilazan $C_6H_{19}NSi_2$ in einem PCVD (plasma activated chemical vapour deposition)-Prozeß auf dem Substrat abgeschieden wird.

10. Verfahren nach Anspruch 9, dadurch gekennzeichnet, daß die dielektrische Schicht (3) in einem auf einen Restgasdruck von $p \approx 10^{-2}$ Pa evakuierten Rezipienten bei einem Prozeßgasdruck im Bereich von 0,5 bis 150 Pa mit einem Gleichspannungspotential an der HF-Elektrode im Bereich von 250 bis 1000 V abgeschieden wird.

11. Verfahren nach den Ansprüchen 9 und 10, dadurch gekennzeichnet, daß vor Einleiten des Prozeßgases Hexamethyldisilazan zunächst Stickstoff bis zu einem Druck von 0,5 bis 150 Pa in den Rezipienten eingeleitet wird und das Plasma bei einem Gleichspannungspotential an der HF-Elektrode im Bereich von 100 bis 1000 V gezündet wird, wonach nach einer Dauer von 20 bis 300 s Hexamethyldisilazan kontinuierlich zugeführt wird bis zu einem Druck von 0,5 bis 150 Pa und der Beschichtungsprozeß bis zum Erreichen der gewünschten Schichtdicke fortgeführt wird.

12. Verfahren nach Anspruch 11, dadurch gekennzeichnet, daß der Beschichtungsprozeß mit einem Gasgemisch aus Hexamethyldisilazan mit einem Stickstoffanteil im Bereich von 0 bis 50 Vol.% durchgeführt wird.

**Claims**

1. A magneto-optical memory having a substrate (1) of a material which is transparent for the visible to infrared spectral range and on which there are provided, in the following sequence, a dielectric layer (3) which is transparent for the visible to infrared spectral range and which has a refractive index which is higher than the refractive index of the substrate and which layer constitutes a diffusion barrier for oxygen and/or water, an essentially amorphous and/or essentially microcrystalline magneto-optical layer (5) with uniaxial anisotropy and a magnetic ordering temperature > ambient temperature and a top layer (7) acting as a reflection or interference layer and as a diffusion barrier layer for oxygen and/or water, characterized in that the dielectric layer is in direct contact with the substrate and can be obtained from hexamethyl disilazane $C_6H_{19}NSi_2$ by means of a PCVD (plasma-activated chemical vapour deposition) process.

2. A magneto-optical memory as claimed in Claim 1, characterized in that a further dielectric layer which is transparent for the visible to infrared spectral range, and which is preferably deposited from hexamethyl disilazane, is provided between the magneto-optical layer (5) and the top layer (7).

3. A magneto-optical memory as claimed in Claims 1 and 2, characterized in that the substrate is made of synthetic resin, more specifically of a polycarbonate.

4. A magneto-optical memory as claimed in Claims 1 and 2, characterized in that the substrate is made of glass.

5. A magneto-optical memory as claimed in one of the preceding Claims 1 to 4, characterized in that the magneto-optical layer (5) consists of a material from a ternary or quaternary system of at least one rare earth metal and at least one transition metal and, optionally, at least a further metallic component.

6. A magneto-optical memory as claimed in Claim 5, characterized in that the magneto-optical layer (5) is made of a material from a ternary or quaternary system of gadolinium and/or terbium and iron and/or cobalt.

7. A magneto-optical memory as claimed in Claim 6, characterized in that the magneto-optical layer (5) consists of gadolinium/terbium/iron or terbium/iron/cobalt.

8. A magneto-optical memory as claimed in one of the preceding Claims 1 to 7, characterized in that the top layer (7) is made of metal or of an oxide, nitride or oxinitride of a metal or a semiconductor.

9. A method of producing a magnetic-optical memory as claimed in Claims 1 to 8 having a substrate of a material which is transparent for the visible to infrared spectral range, on which there are provided, in this sequence, a dielectric layer (3) which is transparent for the visible to infrared spectral range and which has a refractive index which is higher than the refractive index of the substrate and which layer constitutes a diffusion barrier for oxygen and/or water, an essentially amorphous and/or essentially micro-crystalline magneto-optical layer (5) with uniaxial anisotropy and a magnetic ordering temperature > ambient temperature and a top layer (7) acting as a reflection or interference layer and as a diffusion barrier layer for oxygen and/or water, characterized in that the dielectric layer is deposited onto the substrate by means of a PCVD (plasma-activated chemical vapour deposition) process from hexamethyl disilazane $C_6H_{19}NSi_2$.

10. A method as claimed in Claim 9, characterized in that the dielectric layer (3) is deposited in a receptacle, which is evacuated until a residual gas pressure of $p \approx 10^{-2}$ Pa is reached, at a process gas pressure in the range from 0.5 to 150 Pa with a d.c. potential on the HF electrode in the range from 250 to 1000 V.

11. A method as claimed in Claims 9 and 10, characterized in that before the process gas hexamethyl disilazane is introduced into the receptacle, nitrogen is first fed into the receptacle up to a pressure of 0.5 to 150 Pa and the plasma is ignited at a d.c. potential on the HF electrode in the range from 100 to 1000 V, after which, after a period of 20 to 300 s, hexamethyl disilazane is continuously supplied up to a pressure of 0.5 to 150 Pa and the coating process is continued until the desired layer thickness has been reached.

12. A method as claimed in Claim 11, characterized in that the coating process is effected with a gas mixture of hexamethyl disilazane with a nitrogen content in the range from 0 to 50 Vol.%.

**Revendications**

1. Mémoire magnéto-optique munie d'un substrat (1) en un matériau transparent pour la gamme spectrale du visible à l'infra-rouge sur lequel sont appliquées successivement une couche diélectrique transparente (3) pour la gamme spectrale du visible à l'infrarouge qui présente un indice de réfraction supérieur à l'indice de réfraction du substrat et qui constitue une barrière de diffusion pour l'oxygène et/ou l'eau, une couche magnéto-optique (5) essentiellement amorphe et/ou essentiellement microcristalline présentant une anisotropie uniaxiale et une température d'arrangement magnétique supérieure à la température ambiante et une couche de recouvrement (7) faisant office de couche de réflexion ou d'interférence et de barrière de diffusion pour l'oxygène et/ou l'eau, caractérisée en ce que la couche diélectrique est en contact direct avec le substrat et peut être obtenue à partir de hexaméthyldisilazane $C_6H_{19}NSi_2$ par un processus DCVP (plasma activated chemical vapour deposition).

2. Mémoire magnéto-optique selon la revendication 1, caractérisée en ce qu'une autre couche diélectrique transparente pour la gamme spectrale du visible à l'infra-rouge, de préférence une couche déposée en hexaméthyldisilazane, est appliquée entre la couche magnéto-optique (5) et la couche de recouvrement (7).

3. Mémoire magnéto-optique selon la revendication 1 et 2, caractérisée en ce que le substrat en matière synthétique est constitué notamment en un polycarbonate.

4. Mémoire magnéto-optique selon les revendications 1 et 2, caractérisée en ce que le substrat est constitué par du verre.

5. Mémoire magnéto-optique selon l'une des revendications 1 à 4, caractérisée en ce que la couche magnéto-optique (5) est constituée par un matériau en un système ternaire ou quaternaire d'au moins un métal des terres rares et au moins un métal de transition et, le cas échéant, au moins un autre composant métallique.

6. Mémoire magnéto-optique selon la revendication 5, caractérisée en ce que la couche magnéto-optique (5) est constituée par un matériau en un système ternaire ou quaternaire de gadolinium et/ou de terbium et de fer et/ou de cobalt.

7. Mémoire magnéto-optique selon la revendication 6, caractérisée en ce que la couche magnéto-optique (5) est constituée par du gadolinium/terbium/fer ou du terbium/fer/cobalt.

8. Mémoire magnéto-optique selon l'une des revendications précédentes 1 à 7, caractérisée en ce que la couche de recouvrement (7) est constituée par du métal ou un oxyde, nitrure ou oxynitrure de métal ou d'un semiconducteur.

9. Procédé pour la fabrication d'une mémoire magnéto-optique selon les revendications 1 à 8, comportant un substrat en un matériau transparent pour la gamme spectrale du visible à l'infra-rouge sur lequel sont appliquées successivement une couche diélectrique (5) transparente pour la gamme spectrale du visible à l'infra-rouge présentant un indice de réfraction supérieur à l'indice de réfraction du substrat et constituant une barrière de diffusion pour l'oxygène et/ou l'eau, une couche magnéto-optique essentiellement amorphe et/ou essentiellement microcristalline présentant une anisotropie uniaxiale et une température d'arrangement magnétique supérieure à la température ambiante et une couche de recouvrement faisant office de couche de réflexion ou d'interférence et de barrière de diffusion pour l'oxygène et/ou l'eau, caractérisé en ce que la couche diélectrique est déposée à partir de hexaméthyldisilazane $C_6H_{19}NSi_2$ dans un processus DCVP (plasma activated chemical vapour deposition).

10. Procédé selon la revendication 9, caractérisé en ce que la couche diélectrique (3) est déposée dans un récipient vidé jusqu'à une pression résiduelle du gaz de p ≈ $10^{-2}$ Pa sous une pression de gaz de processus située dans la gamme comprise entre 0,5 et 150 Pa à un potentiel de tension continue à l'électrode HF située dans la gamme de 250 à 1000 V.

11. Procédé selon les revendications 9 et 10, caractérisé en ce qu'avant l'introduction du gaz de processus hexaméthyldisilazane, de l'azote est introduit jusqu'à une pression située dans la gamme comprise entre 0,5 et 150 Pa dans le récipient et le plasma est amorcé à un potentiel de tension continue à l'électrode HF dans la gamme de 100 à 1000 V, après quoi, après une durée de 20 à 300 s, de l'hexaméthyldisilazane est amené en régime continu comme gaz de processus jusqu'à une pression située dans la gamme de 0,5 à 150 Pa, après quoi le processus de recouvrement est continué jusqu'à l'obtention de l'épaisseur de couche souhaitée.

12. Procédé selon la revendication 11, caractérisé en ce que le processus de recouvrement est effectué avec un mélange gazeux en hexaméthyldisilazane avec une part en azote de 0 à 50% en volume.